# EUROPEAN PATENT APPLICATION

(11) **EP 4 451 834 A1**
(43) Date of publication of application: **23.10.2024**
(21) Application number: 23168776.5
(22) Date of filing: 19.04.2023
(51) Int. Cl.: H10N 99/00, H01L 33/00

(54) **NARROW BAND MID-INFRARED THERMAL EMITTER**

(71) Applicant: Valstybinis moksliniu tyrimu institutas Fiziniu ir technologijos mokslu centras, 10257 Vilnius (LT)
(72) Inventor: Devenson, Jan, Vilnius (LT); Stasys, Karolis, Vilnius (LT); Krotkus, Arunas, Vilnius (LT)
(74) Representative: Pakeniene, Ausra

(57) **Abstract**

This invention is a narrow band mid-infrared (mid-IR) emitter based on plasmonic thermal emission using solely highly doped 2D III-V group epitaxial layers and comprising two heavily doped layers (2, 4) separated with wide bandgap undoped layer (3) grown on semiconductor substrate (1).

The emission wavelength of a device according to the invention is controlled by changing doping level of the semiconductor layer and by adjusting the dielectric layer thickness. Such device does not need any further processing after growth and can be cleaved to required emitted size.

Such mid-IR emission source is powered using optical pump or heat pump and the emission intensity is controlled by changing the optical pump intensity or heat pump power.

The mid-IR emission source may comprise a heating element integrated at the back of such device crystal for emitting sufficiently strong mid-IR radiation without any external optical excitation devices.

## Description

### TECHNICAL FIELD

The invention relates to a narrow band mid-infrared (mid-IR) emitter based on plasmonic thermal emission.

### BACKGROUND ART

The most common way of fabricating mid-infrared range emitters with narrow wavelength width emission is to use complicated multiple superlattice structures based on III-V group semiconductors, called quantum cascade lasers (QCL) or super light emitting diodes (super-LED). These devices utilize effects of inter-band recombination or inter-sub-band electron transitions for light generation. Unfortunately, these devices require very difficult design structures and extensive processing to have a working device. What is more, these devices are very sensitive to temperature changes. Temperature fluctuations shifts the emission wavelength, thus very careful environmental control is required. Also, increase of temperature greatly reduces electromagnetic radiation emission intensity. Despite, being commonly used sources for mid-IR radiation, QCL and super-LED devices are not very reliable and not suitable for harsh environments or for precise metrological uses.

US patent No.: US9,214,604B2 discloses a thermal Infra-Red, further on referred to as IR, device using a micro-hotplate fabricated on a microchip and enhanced by use of plasmonic structures. The IR device may be an IR source or emitter. The IR source may be provided in the form of a micro-hotplate comprising a heater embedded within a dielectric membrane supported on a silicon substrate where there's at least one layer embedded within or on top of the membrane that has a plasmonic layer which is patterned in a periodic structure to improve the emissivity of the IR source at particular wavelengths. The IR source can be in a form of an array of membranes - closely packed as a result of the use of the deep reactive ion etching technique. Main disadvantage is that the manufacturing of the device requires a patterning process that involves both photolithography and ion etching. This can significantly increase the cost and complexity of the fabrication process.

US patent US8,987,754B1 discloses a heavily directional thermal device comprising a two-dimensional periodic array of heavily doped semiconductor structures on a surface of a substrate, wherein each structure has similar height and side lengths and wherein the periodic array has a characteristic periodicity in each direction, such that the array provides a highly directional thermal emission at a peak wavelength between 3 and 15 microns when array is heated. Main disadvantage is that manufacturing of the device requires formation of a two-dimensional periodic array using photolithography, which can be a complex and costly process. Additionally, the accuracy of the photolithography process strongly affects the emission wavelength, so any errors in the process can lead to variations in the wavelength of the emitted light.

US patent application No.: US13/299,492, publication No.: US20120235067A1, discloses methods of tuning the emission wavelength from a tuneable infrared plasmonic emitting structure, which structure comprises: a perforated or patterned first conductive layer having a plurality of relief features provided in a periodic spatial configuration, wherein the relief features are separated from each other by adjacent recessed features, wherein the distance between features is between 1-15 um; a dielectric layer underlying the first conductive layer; a second conductive layer underlying the dielectric film; and a Substrate underlying the second conductive layer. Main disadvantage of this method is that it relies on thermal plasmonic emission from a structured layer that is either formed within or on top of a polymer layer. This requires additional technological steps such as patterning or perforation, which can increase the fabrication cost of the devices. Additionally, polymers are known to have high temperature dependencies that affect their properties, and they may be less mechanically stable than other materials. Because the emission wavelength is strongly influenced by the distance and periodicity of the pattern features, the stability of the emission wavelength may be lower.

The present invention is dedicated to overcoming of the above shortcomings and for producing further advantages over prior art.

### BRIEF DESCRIPTION OF THE INVENTION

In accordance with one aspect of the invention a narrow band mid-IR radiation emitter comprising of heavily doped 2D III-V group semiconductor structures fabricated on a chip without any photolithography or additional processing is disclosed. The invention exhibits superior wavelength stability and temperature independence which is based on the usage of three differently doped semiconductor layers. The emission wavelength depends on the structure thickness and doping levels and these parameters cannot be affected by temperature changes. What is more, the electromagnetic radiation intensity increases with the increase of heat or light pump intensity. Electromagnetic radiation from the emitter is created when heat from an external source reaches the three differently doped semiconductor layer structure and resonance is achieved. When more heat is trapped between the outer layers of the mentioned structure, more MID-IR electromagnetic radiation is emitted.

The narrow band mid-IR radiation emitter comprises two heavily doped epitaxial layers with a spacer layer formed by molecular beam epitaxy (MBE) between the two heavily doped epitaxial layers. Formation is not limited to MBE method as metal-organic vapor deposition or other crystal growth technique can be used to achieve same or similar result.

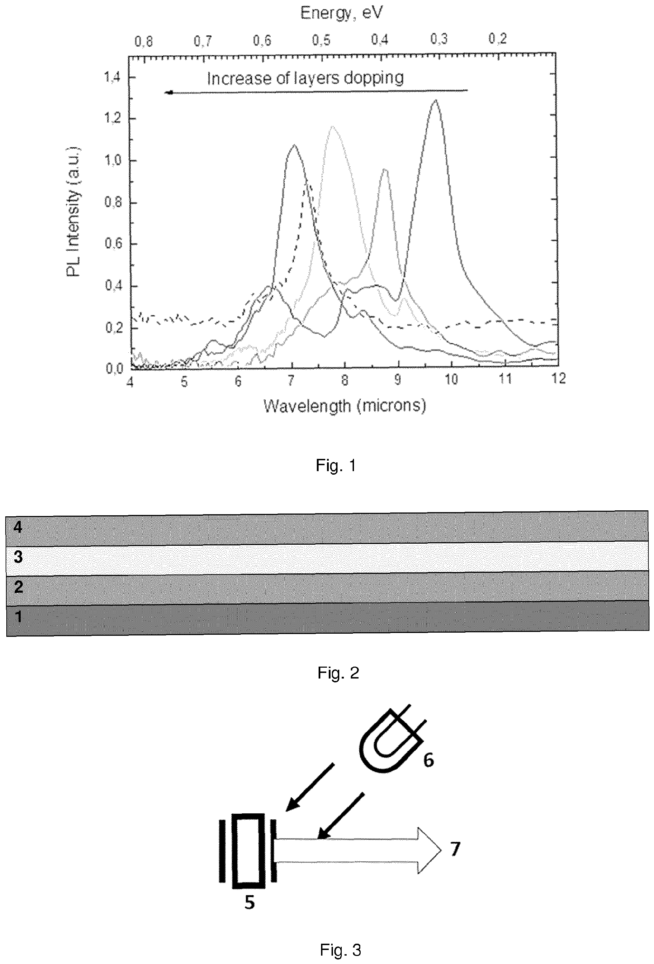

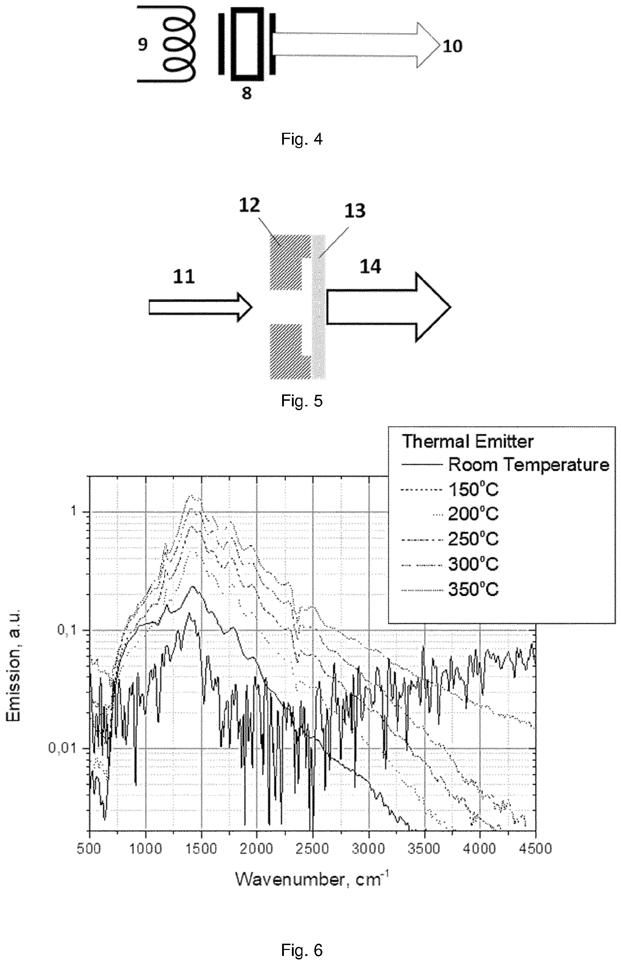

The narrow band mid-IR emitter can be powered using light-pump system, as shown in fig. 3, using external coherent light source with wavelength shorter than the proposed mid-IR source. Alternatively, the narrow band mid-IR emitter can be pumped directly using a heat source, attached to back-end of emitter crystal, as shown in fig. 4. The mid-IR light source is emitted perpendicularly to the crystal.

According to another aspect of the invention a fabrication method of the narrow band mid-IR radiation emitter is disclosed. Firstly, an epitaxially ready wafer is selected for assembly of the narrow band mid-IR emitter structure. Afterwards a first heavily doped layer is made using III-V semiconductor compounds such as InAs doped heavily with Si (doping NSi1) to have large quantity of free charge carriers. This part is very critical for the overall quality of the narrow band mid-IR radiation emitter. Afterwards a spacer layer is grown. The spacer layer is a dielectric layer, made using III-V semiconductor compounds such as InAs doped heavily with Si (doping NSi2) to obtain heavily doped layer having large quantity of free charge carriers. The middle layer, which is not doped at all, allows to reach unrestricted resonance between the first heavily doped layer and the second heavily doped layer, where both layers are outer layers, disposed on opposite sides of the spacer layer, as shown in fig. 2. The first heavily doped layer must have smaller or equal doping (NSi1 ≥ NSi2). After the growth procedure completion, the wafer is diced into 4x4 mm sized squares, and the device is ready to work as emitter. No further processing to the second heavily doped layer is done.

The narrow band mid-IR light emitter emission wavelength is controlled by changing doping amount in both first and second heavily doped layers and by adjusting thickness of the dielectric layer.

### BRIEF DESCRIPTION OF THE DRAWINGS

Features of the invention believed to be novel and inventive are set forth with particularity in the appended claims. The invention itself, however, may be best understood by reference to the following detailed description of the invention, which describes exemplary embodiments, given in non-restrictive examples, of the invention, taken in conjunction with the accompanying drawings, in which:
Fig. 1 shows a graph of the narrow band mid-IR emitter emission spectral dependency on increase of doping amount according to the invention.
Fig. 2. shows crystalline layers (1, 2, 3, 4) of the narrow band mid-IR light emitter according to the invention, where: epitaxially ready wafer (1) serves as substrate for further layer epitaxial growth; a first heavily doped layer (2) is made using III-V semiconductor compounds such as InAs doped heavily with Si (doping NSi1) to provide a large quantity of free charge carriers; a spacer layer (3) is made using III-V semiconductor compounds such as AlSb and acts as a dielectric; second heavily doped layer (4) is made using III-V semiconductor compounds such as InAs, doped heavily with Si.
Fig. 3. shows one embodiment of the narrow band mid-IR emitter light pump scheme, comprising a narrow band mid-IR emitter crystal (5); an external excitation electromagnetic radiation source (6); a mid-IR emitter light emission (7).
Fig. 4. shows another embodiment of the narrow band mid-IR emitter heat pump scheme, comprising a narrow band mid-IR emitter crystal (8); an external excitation heat source (9); a mid-IR emitter light emission (10).
Fig. 5. shows near-infrared (NIR) laser pump scheme, comprising NIR laser emission (11); a wafer holder (12) with an aperture for NIR light inlet; a narrow band mid-IR emitter (13), as shown in Fig. 1, with second heavily doped layer (4) oriented towards outer part (to the right in Fig. 5); a mid-IR emission (14).
Fig. 6 shows a graph of the narrow band mid-IR emitter emission spectral dependency on increase of thermal pump temperature and the temperature-independent emission wavenumber peak position.

Preferred embodiments of the invention will be described herein below with reference to the drawings. Each figure contains the same numbering for the same or equivalent element.

### DETAILED DESCRIPTION OF THE INVENTION

It should be understood that numerous specific details are presented in order to provide a complete and comprehensible description of the invention embodiment. However, the person skilled in art will understand that the embodiment examples do not limit the application of the invention which can be implemented without these specific instructions. Well-known methods, procedures and components have not been described in detail for the embodiment to avoid misleading. Furthermore, this description should not be considered to be constraining the invention to given embodiment examples but only as one of possible implementations of the invention.

In accordance with one aspect of the invention a narrow band mid-IR emitter comprises two heavily doped 2D III-V group semiconductor layers (2,4) fabricated on a wafer (1) without any photolithography or additional processing and a spacer layer (3), being a dielectric layer, in between said two heavily doped layers (2, 4).

The first heavily doped layer (2) is an upper layer and is left without any additional processing in contrast to any previous works. The narrow band mid-IR emitter exhibits superior wavelength stability and temperature independence which is based on the use of the three differently doped semiconductor layers (2, 3, 4) as shown in Fig. 2. The emission wavelength depends on the structure thickness and doping levels and these parameters cannot be affected by temperature changes. The spacer layer (3) is left without additional doping only having intrinsic amount of charge carriers. Electromagnetic radiation intensity increases with increase of heat or light pump intensity. Electromagnetic radiation from the narrow band mid-IR emitter is created when heat from an external source reaches the structure of the three differently doped semiconductor layers (2, 3, 4) and resonance is reached between the first heavily doped layer (2) and the second heavily doped layer (4), while the spacer layer (3) acts as intermediate layer - resonance cavity. When more heat is trapped between the first heavily doped layer (2) and the second heavily doped layer (4) of the mentioned structure, where the first heavily doped layer (2) and the second heavily doped layer (4) are outer layers with respect to the spacer layer (3), more MID-IR electromagnetic radiation is emitted.

The intermittent spacer layer (3) is preferably formed by molecular beam epitaxy (MBE). The spacer layer (3) is not doped at all, allowing to reach unrestricted resonance between the first heavily doped layer (2) and the second heavily doped layer (4). Nevertheless, formation is not limited to MBE method as metal-organic vapor deposition or other crystal growth technique can be used to achieve same or similar result. As an example, main MBE growth parameters are wafer (1) temperature ~450 °C, deoxidation temperature for GaSb wafers is ~540 °C and for InAs wafers is ~525 °C, AlSb layer is grown in 450-480 °C while both InAs layers are grown at ~425 °C. While growing all 3 layers (2, 3, 4), the III and V group semiconductor sources molecular beams should be at stachiometry, meaning that source rates should be at 1:1. These growth parameters should be transferred and adapted accordingly is different growth techniques are used.

The narrow band mid-IR emitter can be powered using light-pump system, as shown in Fig. 3, using external coherent light source with wavelength shorter than the proposed narrow band mid-IR emitter. Alternatively, the narrow band mid-IR emitter can be pumped directly using a heat source, attached to back-end of emitter crystal, as shown in Fig. 4. The narrow band mid-IR emitter light is emitted perpendicularly to the crystal (5).

According to another aspect of the invention, a fabrication method of narrow band the mid-IR radiation emitter is disclosed. Firstly, an epitaxially ready wafer (1) is selected for assembly of the mid-IR emitter structure. Preferably, the wafer (1): is not larger than 5.08 cm in width and 5.08 cm in length, has thickness of 500±25 µm, single or both sides are polished with surface roughness Ra<0,5 nm, crystallographic orientation is [100], EPD value <50000, dopant Sulphur (N type) and carrier concentration lower than 1,5*10¹⁷ cm⁻³.

The wafer (1) is not removed after processing but is left to act as a platform for the overall emitter structure and strengthen plasmonic resonance.

Afterwards the first heavily doped layer (2) is made using III-V semiconductor compounds such as InAs doped heavily with Si (doping NSi1) to have large quantity of free charge carriers. Then a spacer layer (3) is made using III-V semiconductor compounds such as AlSb is deposited and acts as a dielectric. The second heavily doped layer (4) is made using III-V semiconductor compounds such as InAs doped heavily with Si (doping NSi2) to obtain heavily doped layer having large quantity of free charge carriers. The second heavily doped layer (4) must have smaller or equal doping (NSi1 ≥ NSi2). After the growth procedure completion, the wafer (1) is diced into 4x4 mm sized squares, and the device is ready to work as emitter.

The narrow band mid-IR light emitter emission wavelength is controlled by changing doping amount in both heavily doped layers (2, 4) and by adjusting the thickness of the spacer layer (3).

According to one embodiment of the invention and as shown in Fig. 3 a mid-IR emitter light pump comprises a mid-IR emitter crystal (5); an external excitation electromagnetic radiation source (6); a mid-IR source light emission (7).

According to another embodiment of the invention and as shown in Fig. 4, a mid-IR emitter heat pump comprises a mid-IR source crystal (8); an external excitation heat source (9); a mid-IR source light emission (10).

A near-infrared (NIR) laser pump as shown in Fig. 5 comprises a NIR laser emission (11); a wafer holder (12) with an aperture for NIR light inlet; a narrow band mid-IR emitter (13) as shown in Fig. 1, with the second heavily doped layer (4) oriented towards outer part (to the right in Fig. 5); a mid-IR emission (14).

The obtained narrow band Mid-IR emitter according to the inventio can be powered using multiple methods, such as direct heating, pumping with laser emission in front and back and even from sides. Despite the method used to pump the mid-IR source emitter, it exhibited phenomenal emission wavelength stability as seen in Fig. 6. The direct heating applied to the emitter can vary between 50 °C and 350 °C but the emitter emission wavelength does not change at all. The only factor that changed was the intensity, compared between heating temperature of 50 °C and 350 °C or with laser pump energies which varied from 0,3 W up to 1,1 W. The intensity of Mid-IR emission increased in accordance with the heat source power or light pump intensity.

In the light pump (6) scheme, as shown in Fig. 3, a laser source (6) of 800 nm was used as pump source (5). The laser source (6) was directed at an angle of 45° degrees of the narrow band mid-IR emitter crystal (5). The laser source (6) direction angle can vary between 0° and 90 ° degrees. The emitted mid-IR light (7) is perpendicular to the emitter (5).

In the heat pump scheme (Fig. 4), the mid-IR source crystal (8) was welded to a soldering iron which was used as a heat source (9). The emitted mid-IR light (10) is also perpendicular to the emitter (8).

In the NIR laser pump scheme presented in Fig. 5, the near-infrared laser source (11) of 800 nm was used as pump source providing the heat to the mid-IR emitting structure (13) from the substrate side (13) through the inlet aperture (12). The emitted mid-IR light (14) is also perpendicular to the emitter (13).

In all three cases, the same mid-IR emission wavelength was observed.

Narrow band mid-IR emitter emission crystals were grown using different doping and dielectric thickness, which allowed for the control of the mid-IR emission wavelength. The doping levels in heavily doped layers (2, 4) varied from 5*10¹⁷ cm⁻³ up to 1,2*10²⁰ cm⁻³, while the spacer layer (3) thickness varied from 100 nm up to 500 nm.

Having such rugged and reliable mid-IR emission wavelength control, which is independent of temperature changes, opens up new applications in chemical sensing, communication, and especially in metrology. A mid-IR source whose wavelength does not change at all is a reliable etalon that can be used in quality assurance activities. Additionally, the easy development of such mid-IR emission devices shows great economic potential. The simplest and most efficient configuration of such a device comprises a heating element integrated as a high-resistance wire at the back of the device crystal.

Although numerous characteristics and advantages together with structural details and features have been listed in the present description of the invention, the description is provided as an example fulfilment of the invention. Without departing from the principles of the invention, there may be changes in the details, especially in the form, size and layout, in accordance with most widely understood meanings of the concepts and definitions used in claims.

## Claims

1. A narrow band mid-infrared thermal emitter comprising heavily doped semiconductor layers **characterised in that** the narrow band mid-infrared thermal emitter comprises:
an insulating semiconductor wafer layer (1), made from III-V semiconductor compounds;
a first heavily doped semiconductor layer (2), made from III-V semiconductor compounds;
an insulating semiconductor spacer layer (3), made from III-V semiconductor compounds different than III-V semiconductor compounds used for making first and second heavily doped layers (2, 4);
a second heavily doped semiconductor layer (4), made from the same III-V semiconductor compounds as the first highly doped semiconductor layer (2) but with lower doping level without any epitaxially processed surface.

2. Method for control of emission of a narrowband mid-infrared thermal emitter, **characterised in that** comprises:
changing doping ratio of a first heavily doped semiconductor layer (2) and second heavily doped semiconductor layer (4) which adjusts the emission wavelength peak position;
changing thickness of an insulating semiconductor spacer layer (3);
controlling intensity of an external heat source (9) to adjust the mid-IR emission source (8) wavelength peak intensity.
